# EUROPEAN PATENT SPECIFICATION

(11) **EP 2 285 198 B1**
(45) Date of publication and mention of the grant of the patent: **28.01.2015**
(21) Application number: 10005757.9
(22) Date of filing: 02.06.2010
(51) Int. Cl.: H05K 5/04, G06F 1/16

(54) **Modular building block type chassis**
Unterbau des modularen Baueinheittyps
Châssis de type bloc de construction modulaire

(30) Priority: 11.08.2009 TW 098214730
(43) Date of publication of application: 16.02.2011
(73) Proprietor: Caswell Inc., Shulin City T'ai pei 23845 (TW)
(72) Inventor: Hung, Te-Fe, Shulin City Taipei County 23845 (TW)
(74) Representative: Zeitler, Giselher

(56) References cited:
- EP-A2- 1 437 929
- WO-A1-2004/015554
- WO-A1-2008/085016
- DE-C1- 4 416 004

## Description

### BACKGROUND OF THE INVENTION

### 1. Field of the Invention

The present invention relates to a chassis device, and more particularly to a modular building block type chassis with excellent installation and application effects to facilitate the assembling, connection and expandability of a chassis.

### 2. Description of the Related Art

Computer has become a necessary tool for our life, work and entertainment, and a conventional desktop computer generally comes with a screen connected to a main system and occupies much space. The large-size desktop computer facilitates its expansion function, and thus the desktop computer always has existing values. However, the large size also brings inconvenience to its disposition, and may even cause problems to users who have very limited space. Therefore, a mini-desktop computer reducing the size of a regular desktop computer was introduced to the market. Although the mini-desktop computer can maximize the utility of space, the small size also limits or even prohibits the expansion function of the mini-desktop computer. When present existing desktop computers are assembled, it is necessary to assemble four panels, an upper case and a lower case by screws one by one, and thus the assembling process is time-consuming, which is unfavorable for the cost-effectiveness of the manufacture. Furthermore, the panels of the present existing desktop computers do not come with a universal design, and thus making the material preparation, tool adjustment, and assembling process more complicated and time-consuming, and resulting in a low cost-effectiveness.

Since selling price is a main factor that determines the competitiveness of a computer, it is an important subject for manufacturers to provide an excellent manufacturing process to improve the cost-effectiveness and lower the cost and a feasible solution to break through the existing issues, so as to offer a better expandability of a computer in a smaller space. Obviously, it is an important subject for manufacturers to overcome the existing shortcomings of the prior art by providing a modular building block type chassis and improve the cost-effectiveness, convenience and flexibility of using a computer.

Patent publications DE 4416004 C1, EP 1 437 929 A2, WO 2004/015554 A1 and WO 2008/085 016 A1 disclose examples of modular building block types of chassis.

In view of the shortcomings of the conventional computer chassis, the inventor of the present invention based on years of experience in the related industry to conduct extensive researches and experiments, and finally developed a more economic, convenient and expandable modular building block type chassis in accordance with the present invention.

### SUMMARY OF THE INVENTION

Therefore, it is a primary objective of the present invention to overcome the aforementioned shortcomings and deficiencies of the prior art by providing a modular building block type chassis that adopts panels to define the external periphery of the chassis, such that the manufacture and assembling of the chassis can be very convenient and efficient to achieve the effects of simplifying the manufacturing process effectively, reducing the manufacturing time significantly, and lowering the cost effectively.

Another objective of the present invention is to provide a modular building block type chassis with an excellent expandability and a convenient space utility, such that the chassis can be assembled and applied conveniently and flexibly, and the cost-effectiveness can be improved significantly.

To achieve the foregoing objective, the present invention according to claim 1 provides a modular building block type chassis comprising: a plurality of panels for defining the external periphery of the chassis, and an embedding panel separately disposed at both ends of each panel, wherein the panels are boards with an equal thickness and an equal height; a plurality of connecting elements, each having an embedding groove formed in a vertical direction on both sides of each connecting element for embedding and connecting the embedding panel, at least one fixing pillar disposed on an internal side of the connecting element, and a longitudinally open fixing hole formed on the fixing pillar; at least one upper case, having a fixing hole formed at a corner of the upper case and provided for coupling the longitudinally open fixing hole of the fixing pillar by a coupling element; at least one lower case, having a fixing hole formed at a corner of the lower case and fixed to the longitudinally open fixing hole of the fixing pillar by a coupling element.

The main advantage of the present invention includes the convenience and cost-effectiveness of the manufacturing and assembling processes, while maximizing the utility of spaces for system expansion.

The technical characteristics of the present invention will become apparent with the detailed description of the preferred embodiments and the illustration of the related drawings as follows.

### BRIEF DESCRIPTION OF THE DRAWINGS

FIG. 1 is an exploded view of a first preferred embodiment of the present invention;
FIG. 2 is an enlarged exploded view of a portion of a first preferred embodiment of the present invention;
FIG. 3 is a partial exploded view of a first preferred embodiment of the present invention;
FIG. 4 is a partial exploded view of a second preferred embodiment of the present invention;
FIG. 5 is a perspective view of a second preferred embodiment of the present invention;
FIG. 6 is a perspective view of a third preferred embodiment of the present invention;
FIG. 7 is a partial exploded view of a third preferred embodiment of the present invention;
FIG. 8 is a perspective view of a third preferred embodiment of the present invention;
FIG. 9 is a partial exploded view of a fourth preferred embodiment of the present invention; and
FIG. 10 is a perspective view of a fourth preferred embodiment of the present invention.

### DETAILED DESCRIPTION OF THE PREFERRED EMBODIMENTS

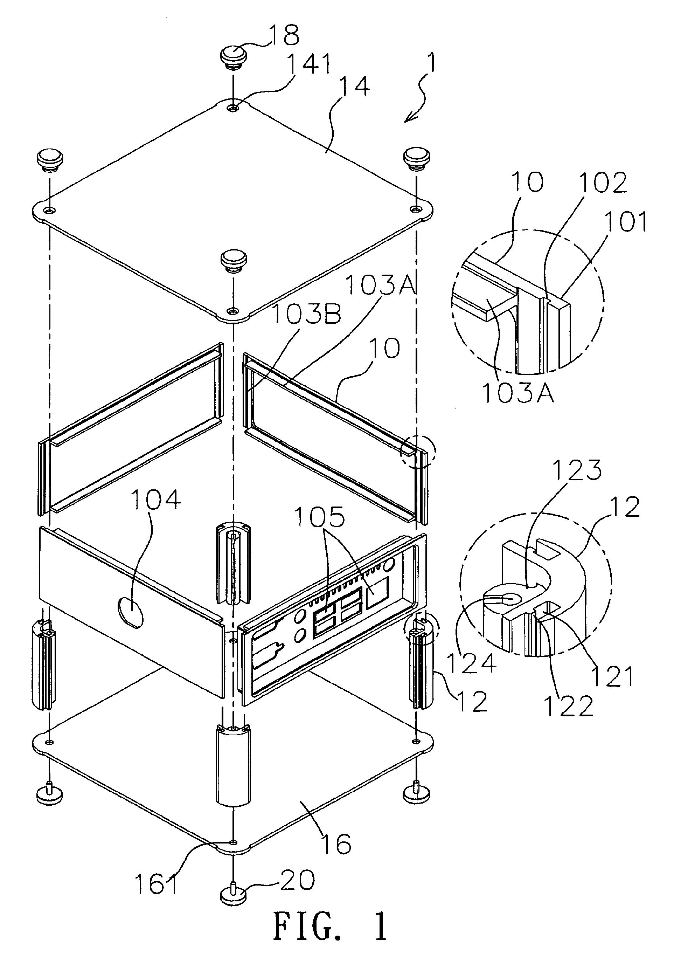

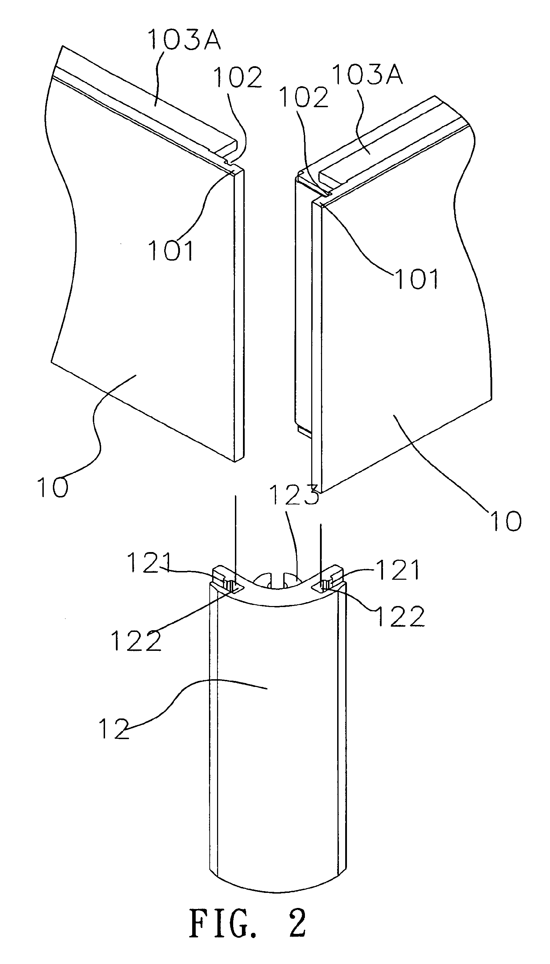

With reference to FIGS. 1 to 3 for a modular building block type chassis in accordance with a first preferred embodiment of the present invention, the modular building block type chassis 1 comprises four panels 10, a plurality of connecting elements 12, an upper case 14, and a lower case 16, wherein the panels 10 are provided for defining the external periphery of the chassis 1, and an embedding panel 101 is separately disposed at both ends of each panel 10, and a connecting slot 102 is formed at an appropriate position on an internal side (or an external side) of the embedding panel 101, and a connecting plate 103A, 103B is separately formed at upper, lower, left and right ends of the internal side of the panel 10. In this preferred embodiment, the four panels 10 are boards having an equal thickness and an equal height, so that a long-strip board can be stamped to produce a plurality of panels 10 with a same length or a different length to simplify the material preparation, tool preparation and manufacturing processes. The panel 10 may include a through hole 104 (such as a power switch installation hole), and a plurality of external connection holes 105 (such as I/O installation holes) according to the requirements of the application. The connecting element 12 comes with two connecting ends for a side pillar, and having an embedding groove 121 formed in a vertical direction and separately disposed on both sides of the connecting element 12, and the embedding groove 121 includes a connecting rib 122 corresponding to the connecting slot 102, and the connecting element 12 includes a fixing pillar 123 installed on an internal side of the connecting element 12, and the fixing pillar 123 includes a longitudinally open fixing hole 124. The upper case 14 is a board having a fixing hole 141 formed at a corner of the board. The lower case 16 is also a board having a fixing hole 161 formed at a corner of the board. The fixing holes 141, 161 are disposed at upper and lower positions corresponding to the fixing hole 124 of the fixing pillar 123 respectively.

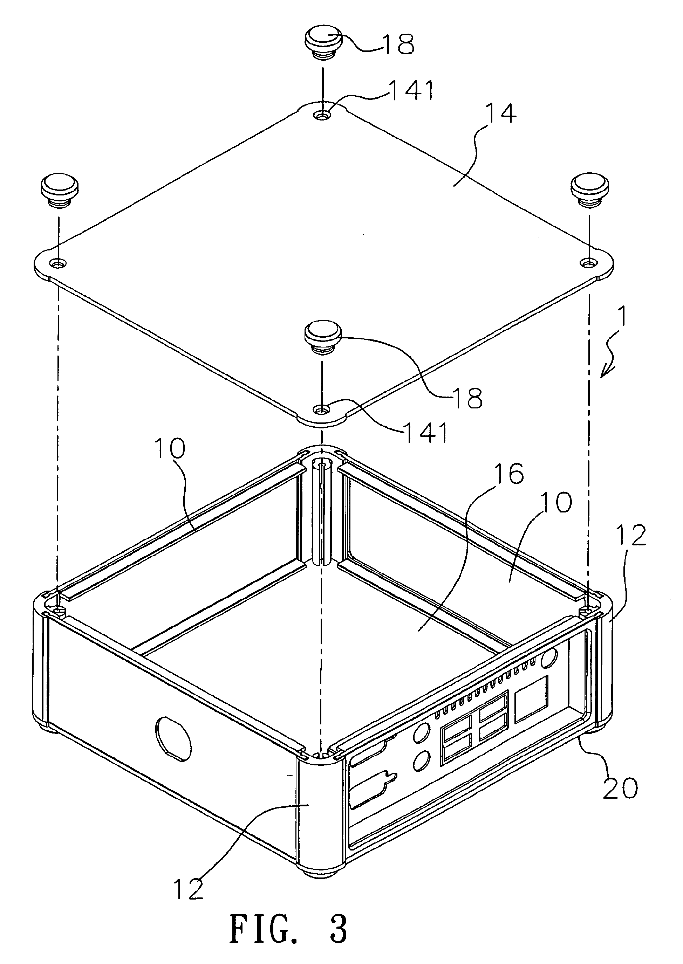

When the modular building block type chassis of the present invention is assembled, the panel 10 is embedded longitudinally (or in a vertically up-and-down direction) between the connecting elements 12 at both ends, such that embedding panels 101 at both ends of the panel 10 can be embedded into the embedding grooves 121 of the connecting element 12 respectively, and the connecting rib 122 and the connecting slot 102 can be embedded and coupled with each other to provide a quick and convenient way of assembling and positioning the panels 10 (as shown in FIG. 3). The upper case 14 and the lower case 16 are fixed to upper and lower positions of the fixing hole 124 of the connecting element 12 by the coupling elements 18, 20 respectively, such that the upper case 14 and the lower case 16 can be installed onto upper and lower positions of the modular building block type chassis 1 respectively to provide a quick and convenient assembling operation.

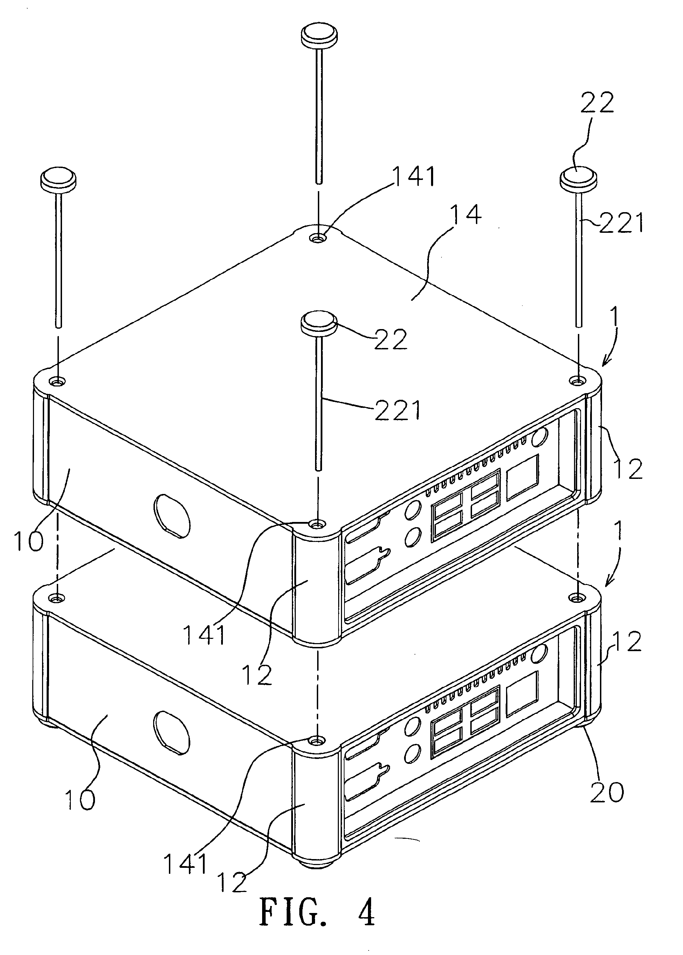

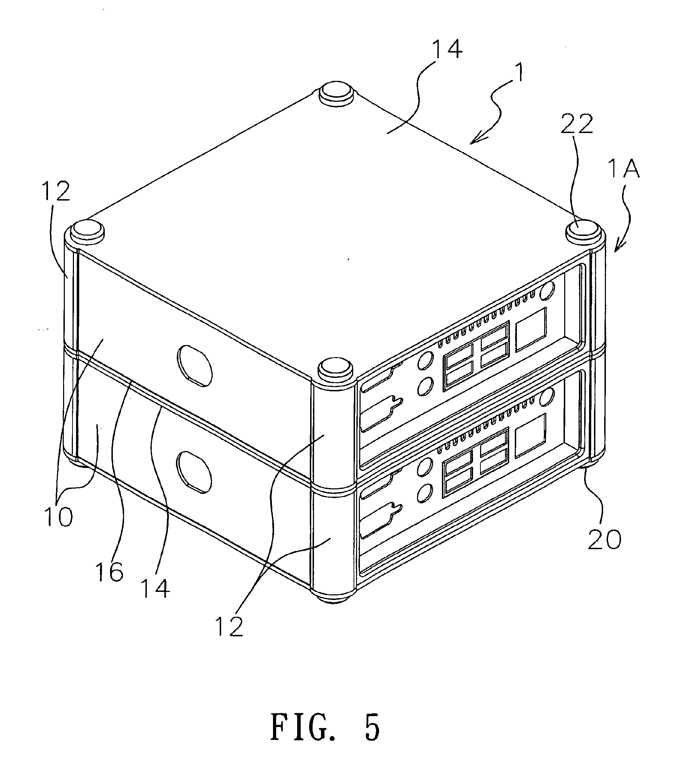

With reference to FIGS. 4 and 5 for a modular building block type chassis in accordance with a second preferred embodiment of the present invention, the modular building block type chassis 1 is based on the structure of the first preferred embodiment and stacked for an expansion. Two (upper and lower) modular building block type chassises 1 are stacked before they are fixed to the upper case 14, and then the upper and lower modular building block type chassises 1 are fixed by a coupling element 22, wherein the coupling element 22 includes a slender coupling rod 221 passed through the upper and lower fixing holes 141 and fixed to fixing hole 124 (not shown in the figure) at a lower connecting element 12 to complete the expansion of the chassis 1A (as shown in FIG. 5), and the stacked and expanded chassis 1A is a good solution for users (or manufacturers) who require a system expansion.

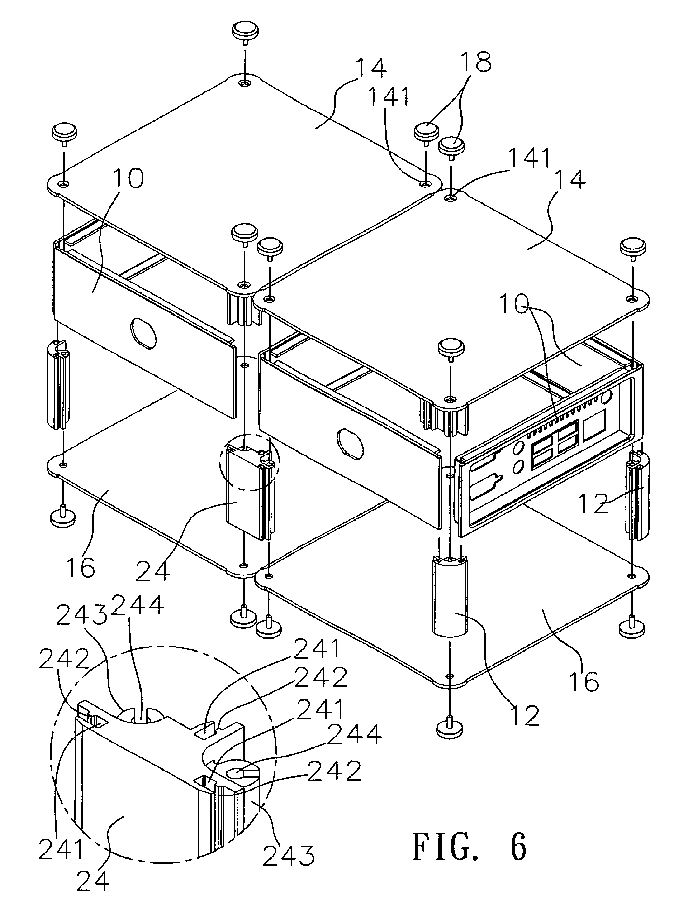

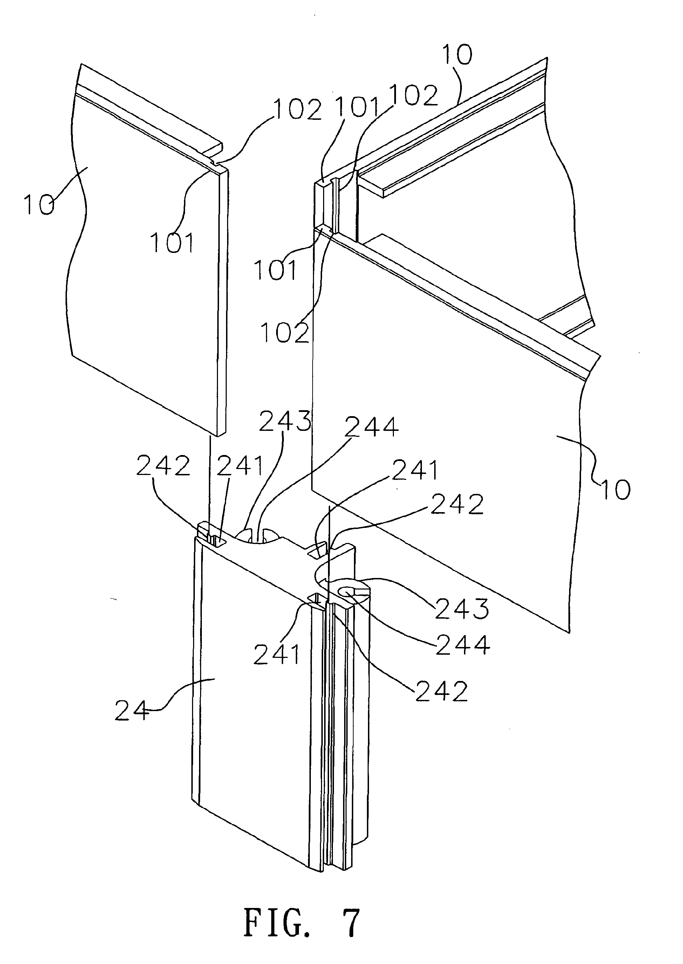

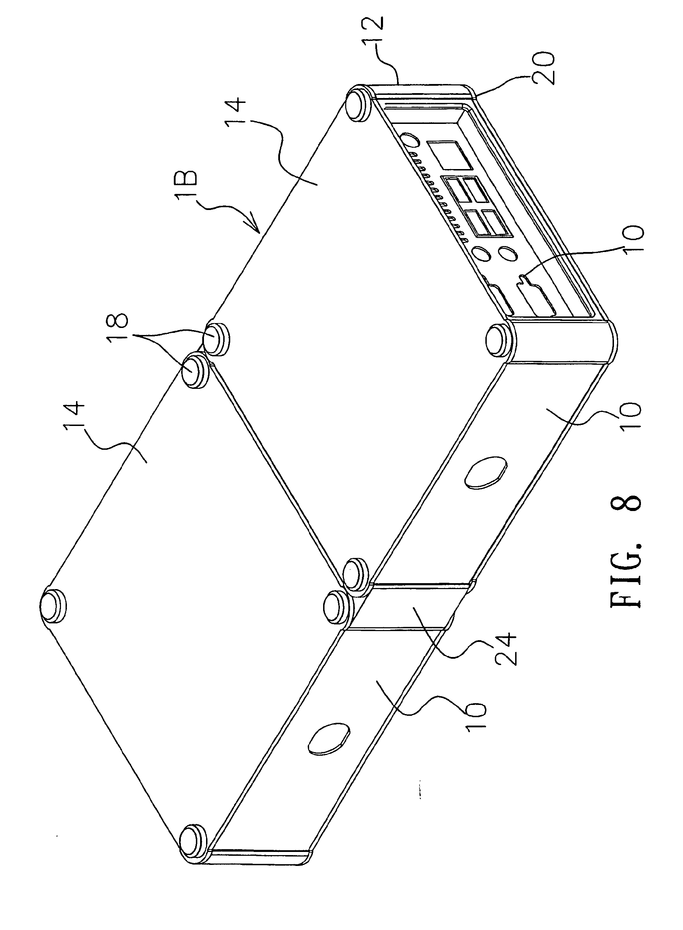

With reference to FIGS. 6 to 8 for a modular building block type chassis in accordance with a third preferred embodiment of the present invention, the modular building block type chassis 1 is based on the structure of the first preferred embodiment and installed adjacently in a row for an expansion, wherein the connecting element 24 for the adjacent modular building block type chassis 1 comes with three connecting ends, and an embedding groove 241 is separately formed on both sides of the connecting element 24 and in a vertical direction of an internal side of the connecting element 24. The embedding groove 241 also includes a connecting rib 242 corresponding to the connecting slot 102, and the connecting element 24 includes a fixing pillar 243 separately disposed on both sides of the connecting element 24, and the fixing pillar 243 also includes a longitudinally open fixing hole 244, such that two adjacent modular building block type chassises 1 can save one of the adjacent panels 10. Since the connecting element 24 is provided for fixing two adjacent panels 10 and a middle partitioning panel 10 to complete installing a chassis 1B (as shown in FIG. 8) in a row for an expansion, which is a good solution for users (or manufacturers) who require a system expansion.

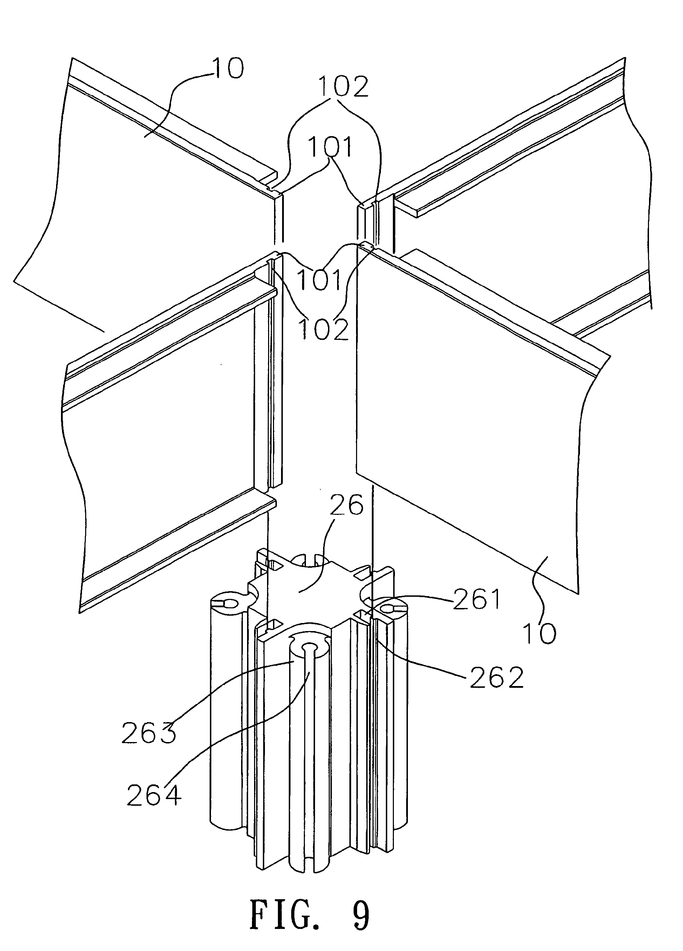

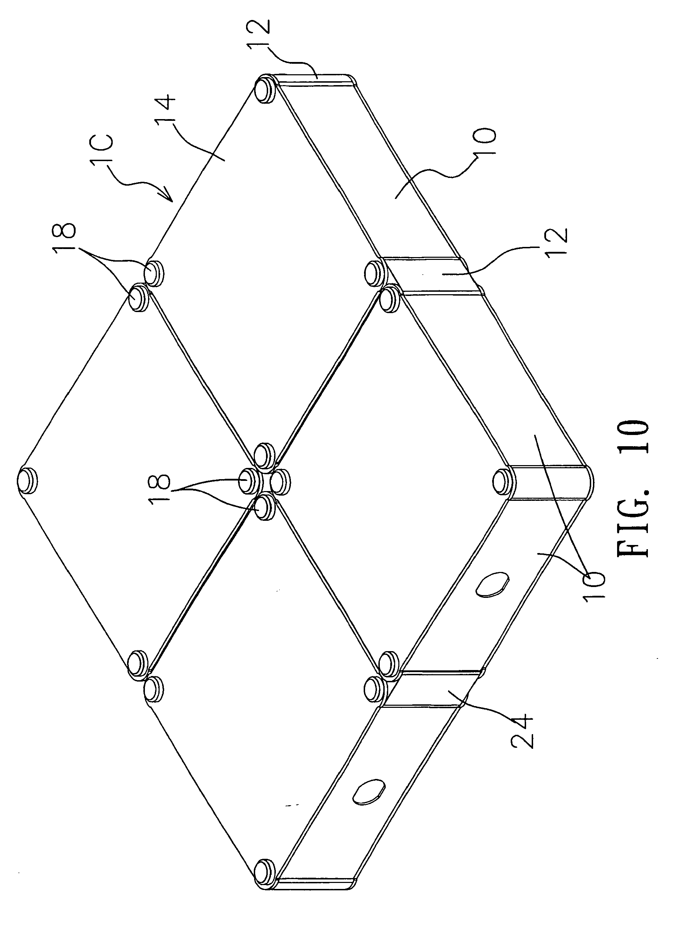

With reference to FIGS. 9 and 10 for a modular building block type chassis in accordance with a fourth preferred embodiment of the present invention, the modular building block type chassis 1 is based on the structure of the third preferred embodiment and installed adjacent to another modular building block type chassis 1B, wherein the connecting element 26 at the central position comes with four connecting ends, and the connecting element 26 includes an embedding groove 261 separately formed on four sides of the connecting element 26, and the embedding groove 261 also includes a connecting rib 262 corresponding to the connecting slot 102, and the connecting element 26 includes a fixing pillar 263 separately installed at four corners of the connecting element 26 respectively, and the fixing pillar 263 also includes a longitudinally open fixing hole 264. Therefore, two adjacent modular building block type chassises 1 can save one of the adjacent panels 10 (and there are four of them in this preferred embodiment). Since the connecting element 26 is provided for fixing two adjacent panels 10 and a middle partitioning panel 10, and the connecting element 26 is provided for fixing four connected panels 10 at the middle, therefore an expanded chassis 1C (as shown in FIG. 10) can be installed for an expansion, which is a good solution for users (or manufacturers) who require a system expansion.

In the modular building block type chassis of the present invention, the panels can be assembled quickly to provide a convenient and efficient manufacture of a computer chassis and achieve the effects of simplifying the manufacturing process, reducing the manufacturing process, and lowering the cost, and different combinations of the modular building block type chassises allow users to configure the best utility of spaces and provide an excellent and convenient expandability. Obviously, the present invention can improve the cost-effectiveness and the product competitiveness.

In summation of the description above, the present invention improves over the prior art and complies with patent application requirements, and thus is duly filed for the patent application.

## Claims

1. A modular building block type chassis (1), comprising:
a plurality of panels (10), for defining the external periphery of the chassis (1), and having an embedding panel (101) separately disposed at both ends of the panels (10), and the plurality of panels (10) being boards with an equal thickness and an equal height;
a plurality of connecting elements (12), each having an embedding groove (121) vertically formed and separately disposed on both sides of the connecting element (12) for embedding and coupling the embedding panel (101), at least one fixing pillar (123) installed on an internal side of the connecting element (12), and a fixing hole (124) formed on the fixing pillar (123);
at least one upper case (14), having a fixing hole (141) formed at a corner of the upper case (14) and fixed to the fixing hole (124) of the fixing pillar (123) by a coupling element (18);
at least one lower case (16), having a fixing hole (161) formed at a corner of the lower case (16) and fixed to the fixing hole (124) of the fixing pillar (123) by a coupling element (20).

2. The modular building block type chassis (1) of claim 1, wherein the embedding panel (101) includes a connecting slot (102) formed on an internal side or an external side of the embedding panel (101).

3. The modular building block type chassis (1) of claim 2, wherein the embedding groove (121) includes a connecting rib (122) corresponding to the connecting slot (102).

4. The modular building block type chassis (1) of claim 1, wherein the panel includes a connecting plate (103A, 103B) separately installed to an upper end, a lower end, a left end and a right end of the internal side of the panel (10).

5. The modular building block type chassis (1) of claim 1, wherein the plurality of panels (10) are made by stamping a long-strip board.

6. The modular building block type chassis (1) of claim 1, wherein the panel (10) includes a through hole (104) or a plurality of external connection holes (105).

7. The modular building block type chassis (1) of claim 1, wherein the coupling element (18) provided for fixing the upper case (14) includes a slender coupling rod (221), such that the modular building block type chassis (1) can be stacked through the slender coupling rod (221) for an expansion.

8. The modular building block type chassis (1) of claim 1, wherein the connecting element (24) comes with three connecting ends, and the embedding groove (241) and the connecting rib (242) on the embedding groove (241) are vertically and respectively disposed on both sides and internal side of the connecting element (24), and the fixing pillar (243) and the longitudinally open fixing hole (244) on the fixing pillar (243) are vertically and respectively disposed on both sides of the connecting element (24), such that the modular building block type chassis (1) can be installed in a row for an expansion.

9. The modular building block type chassis (1) of claim 1, wherein the connecting element (26) comes with four connecting ends, and the embedding groove (261) and the connecting rib (262) on the embedding groove (261) are disposed on four sides of the connecting element (26) respectively, and the fixing pillar (263) and the longitudinally open fixing hole (264) on the fixing pillar (263) are disposed at four corners of the connecting element (26) respectively, such that the modular building block type chassis (1) can be installed in a row for an expansion.

## Patentansprüche

1. Modulares Baukastengestell (1), umfassend eine Vielzahl von Tafeln (10) zur Bildung des äußeren Umfangs des Gestells (1) und eine Einbettungsplatte (101), die an beiden Enden der Tafeln (10) getrennt angeordnet ist, wobei die Vielzahl der Tafeln (10) Planken mit gleicher Dicke und gleicher Höhe sind; ferner umfassend mehrere Verbindungselemente (12), von denen jedes eine Einbettungsnut (121) aufweist, die senkrecht ausgebildet und getrennt auf beiden Seiten des Verbindungselementes (12) angeordnet ist, um die Einbettungsplatte (101) einzubetten und zu koppeln, wobei wenigstens eine Befestigungsrolle (121) auf einer Innenseite des Verbindungselements (12) angeordnet ist und ein Befestigungsloch (124) auf der Befestigungssäule (123) ausgebildet ist; des weiteren umfassend ein oberes Gehäuse (14) mit einem Befestigungsloch (141), das sich an einer Ecke des oberen Gehäuses (12) befindet und an dem Befestigungsloch (124) der Befestigungssäule (123) durch ein Kupplungselement (18) angebracht ist; und schließlich umfassend wenigstens ein unteres Gehäuse (16) mit einem Befestigungsloch (161), das an einer Ecke des unteren Gehäuses (16) ausgebildet ist und mit dem Befestigungsloch (124) der Befestigungssäule (123) durch ein Kupplungselement (20) fest verbunden ist.

2. Modulares Baukastengestell (1) nach Anspruch 1, **dadurch gekennzeichnet, daß** die Einbettungstafel (101) einen Verbindungsschlitz (102) aufweist, der auf einer Innenseite oder einer Außenseite der Einbettungstafel (101) ausgebildet ist.

3. Modulares Baukastengestell (1) nach Anspruch 2, **dadurch gekennzeichnet, daß** die Einbettungsnut (121) eine Verbindungsrippe (122) besitzt, die dem Verbindungsschlitz (102) entspricht.

4. Modulares Baukastengestell (1) nach Anspruch 1, **dadurch gekennzeichnet, daß** die Tafel eine Verbindungsplatte (102A, 103B) aufweist, die an einem oberen Ende, einem unteren Ende, einem linken Ende und einem rechten Ende der Innenseite der Tafel (10) getrennt installiert ist.

5. Modulares Baukastengestell (1) nach Anspruch 1, **dadurch gekennzeichnet, daß** die Vielzahl der Tafeln (10) durch Stanzen einer langen Streifenplanke hergestellt sind.

6. Modulares Baukastengestell (1) nach Anspruch 1, **dadurch gekennzeichnet, daß** die Tafel (10) ein Durchgangsloch (104) oder eine Vielzahl von äußeren Verbindungslöchern aufweist.

7. Modulares Baukastengestell (1) nach Anspruch 1, **dadurch gekennzeichnet, daß** das Kupplungselement (18), das zur Befestigung des oberen Gehäuses (14) dient, eine dünne Kupplungsstange (221) aufweist, so daß das modulare Baukastengestell (1) zwecks Ausdehnung durch die dünne Kupplungsstange (221) zusammengesteckt werden kann.

8. Modulares Baukastengestell (1) nach Anspruch 1, **dadurch gekennzeichnet, daß** das Verbindungselement (24) drei Verbindungsenden aufweist und die Einbettungsnut (241) sowie die Verbindungsrippe (242) auf der Einbettungsnut (241) senkrecht verlaufen und auf beiden Seiten und der Innenseite des Verbindungselements (24) entsprechend angeordnet sind, und die Befestigungssäule (243) und das in Längsrichtung verlaufende Befestigungsloch (244) auf der Befestigungssäule (243) senkrecht ausgebildet sind und entsprechend auf beiden Seiten des Verbindungselementes (24) so angeordnet sind, daß das modulare Baukastengestell (1) zwecks Ausdehnung in einer Reihe installiert werden kann.

9. Modulares Baukastengestell (1) nach Anspruch 1, **dadurch gekennzeichnet, daß** das Verbindungselement (26) vier Verbindungsenden aufweist und die Einbettungsnut (261) sowie die Verbindungsrippe (262) auf der Einbettungsnut (261) auf vier Seiten des Verbindungselementes (26) entsprechend angeordnet sind, während die Befestigungssäule (263) und das in Längsrichtung offene Befestigungsloch (264) auf der Befestigungssäule (263) an vier Ecken des Verbindungselementes (26) entsprechend liegen, so daß das modulare Baukastengestell (1) zwecks Ausdehnung in einer Reihe eingebaut werden kann.

## Revendications

1. Châssis modulaire (1) du type "bloc de construction", comprenant :
une pluralité de panneaux (10) pour définir la périphérie externe du châssis (1) et ayant un panneau d'encastrement (101) disposé séparément aux deux extrémités des panneaux (10), et la pluralité de panneaux (10) étant des cartes avec une épaisseur égale et une hauteur égale ;
une pluralité d'éléments de connexion (12), chacun ayant une rainure d'encastrement (121) formée verticalement et disposée séparément sur les deux côtés de l'élément de connexion (12) pour encastrer et coupler le panneau d'encastrement (101), au moins un pilier de fixation (123) installé sur un côté interne de l'élément de connexion (12), et un trou de fixation (124) formé sur le pilier de fixation (123) ;
au moins un casier supérieur (14) ayant un trou de fixation (141) formé à un coin du casier supérieur (14) et fixé au trou de fixation (124) du pilier de fixation (123) par un élément de couplage (18) ;
au moins un casier inférieur (16) ayant un trou de fixation (161) formé à un coin du casier inférieur (16) et fixé au trou de fixation (124) du pilier de fixation (123) par un élément de couplage (20).

2. Châssis modulaire (1) du type "bloc de construction" selon la revendication 1, dans lequel le panneau d'encastrement (101) inclut une fente de connexion (102) formée sur un côté interne ou sur un côté externe du panneau d'encastrement (101).

3. Châssis modulaire (1) du type "bloc de construction" selon la revendication 2, dans lequel la gorge d'encastrement (121) inclut une nervure de connexion (122) correspondant à la fente de connexion (102).

4. Châssis modulaire (1) du type "bloc de construction" selon la revendication 1, dans lequel le panneau inclut une plaque de connexion (103A, 103B) installée séparément à une extrémité supérieure, une extrémité inférieure, une extrémité gauche et une extrémité droite du côté interne du panneau (10).

5. Châssis modulaire (1) du type "bloc de construction" selon la revendication 1, dans lequel la pluralité de panneaux (10) sont réalisés par estampage d'une carte en bande longue.

6. Châssis modulaire (1) du type "bloc de construction" selon la revendication 1, dans lequel le panneau (10) inclut un trou traversant (104) ou une pluralité de trous de connexion externe (105).

7. Châssis modulaire (1) du type "bloc de construction" selon la revendication 1, dans lequel l'élément de couplage (18) prévu pour fixer le casier supérieur (14) inclut une tige de couplage élancée (221), de sorte que le châssis modulaire (1) du type "bloc de construction" peut être empilé au moyen de la tige de couplage élancée (221) pour une extension.

8. Châssis modulaire (1) du type "bloc de construction", selon la revendication 1, dans lequel l'élément de connexion (24) comporte trois extrémités de connexion, et la gorge d'encastrement (241) et la nervure de connexion (242) sur la gorge d'encastrement (241) sont disposées verticalement et respectivement sur les deux côtés et sur le côté interne de l'élément de connexion (24), et le pilier de fixation (243) et le trou de fixation ouvert longitudinalement (244) sur le pilier de fixation (243) sont disposés verticalement et respectivement sur les deux côtés de l'élément de connexion (24), de sorte que le châssis modulaire (1) du type "bloc de construction" peut être installé dans une rangée pour une extension.

9. Châssis modulaire (1) du type "bloc de construction" selon la revendication 1, dans lequel l'élément de connexion (26) comporte quatre extrémités de connexion, et la gorge d'encastrement (261) et la nervure de connexion (262) sur la gorge d'encastrement (261) sont disposées sur quatre côtés de l'élément de connexion (26) respectivement, et le pilier de fixation (263) et le trou de fixation ouvert longitudinalement (264) sur le pilier de fixation (263) sont disposés à quatre coins de l'élément de connexion (26) respectivement, de sorte que le châssis modulaire (1) du type "bloc de construction" peut être installé dans une rangée pour une extension.
